(19) Europäisches Patentamt
European Patent Office
Office européen des brevets

(11) **EP 3 247 674 B1**

(12) **EUROPÄISCHE PATENTSCHRIFT**

(45) Veröffentlichungstag und Bekanntmachung des Hinweises auf die Patenterteilung:
**02.01.2019 Patentblatt 2019/01**

(21) Anmeldenummer: **15797033.6**

(22) Anmeldetag: **06.11.2015**

(51) Int Cl.:
**B81B 7/00** *(2006.01)*

(86) Internationale Anmeldenummer:
**PCT/EP2015/075947**

(87) Internationale Veröffentlichungsnummer:
**WO 2016/116183 (28.07.2016 Gazette 2016/30)**

(54) **MODUL MIT SPANNUNGSFREI BEFESTIGTEM MEMS-BAUELEMENT**

MODULE COMPRISING A MEMS COMPONENT MOUNTED WITHOUT SUBJECTING SAME TO STRESS

MODULE POURVU D'UN COMPOSANT MEMS FIXÉ SANS CONTRAINTE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.01.2015 DE 102015100757**

(43) Veröffentlichungstag der Anmeldung:
**29.11.2017 Patentblatt 2017/48**

(73) Patentinhaber: **TDK Corporation Tokyo 108-0023 (JP)**

(72) Erfinder: **ROMBACH, Pirmin Hermann Otto DK-2800 Kongens Lyngby (DK)**

(74) Vertreter: **Epping - Hermann - Fischer Patentanwaltsgesellschaft mbH Schloßschmidstraße 5 80639 München (DE)**

(56) Entgegenhaltungen:
**EP-A2- 2 006 248        WO-A1-2014/094831
DE-A1-102010 012 042    US-A1- 2003 038 415
US-A1- 2010 157 562**

**Beschreibung**

Die Erfindung betrifft Module, bei denen ein MEMS-Bauelement über einen breiten Temperaturbereich spannungsfrei befestigt ist.

MEMS-Bauelemente (MEMS = Micro-Electro-Mechanical System) umfassen mechanisch aktive Strukturen, die häufig empfindlich auf mechanische Spannungen reagieren. Ein MEMS-Bauelement kann beispielsweise ein elektroakustischer Wandler sein, der zusammen mit einem ASIC-Chip (ASIC = Application Specific Integrated Circuit) auf einem Träger eines Mikrofon-Moduls befestigt und verschaltet ist. Der Wandler kann dabei eine schwingfähige Membran und eine Rückplatte (englisch: back plate) aufweisen, die zwei Elektroden eines Kondensators bilden. Schwingungen der Membran relativ zur Rückplatte bedingen eine zeitlich variierende Kapazität. Durch Auswerten der Kapazität, z. B. durch einen ASIC, kann ein Tonsignal in ein elektrisches Signal gewandelt werden.

Problematisch ist, dass Träger und das Material des Wandlers im Allgemeinen verschiedene thermische Ausdehnungskoeffizienten (CTE: Coefficient of Thermal Expansion) aufweisen. Bei einer Temperaturänderung werden mechanische Spannungen über die Verbindungen zwischen Träger und Wandler an den Wandler weitergegeben. Mechanische Spannungen im Wandler verhindern ein ungestörtes Arbeiten der mechanischen Strukturen, sodass sich Temperaturänderungen negativ auf die Signalqualität des Mikrofons auswirken.

Temperaturinduzierte Störungen gibt es nicht nur bei Mikrofonen. Prinzipiell sind alle MEMS-Bauelement, z. B. auch Drucksensoren oder mit akustischen Wellen arbeitende Filterkomponenten, betroffen.

Der anhaltende Trend zu immer weitergehender Miniaturisierung, der z. B. dünnere MEMS-Bauelements verlangt, verstärkt diese Problematik, denn dünnere Bauelement verformen sich unter Einwirkung äußerer Kräfte stärker.

Aus der DE 102010012042 A1 sind elektrische Bauelemente mit einem Chip, der mit einer mechanische Spannungen reduzierenden Aufhängung befestigt ist, bekannt.

Aus der US 2003/038415 A1 sind Sensorsysteme und Packages für Sensoren zum Schutz eines Sensors vor thermischen und mechanischen Einflüssen bekannt.

Aus der US 2010/157562 A1 ist die Verwendung von elastischen Befestigungselementen bekannt.

Aus der EP 2006248 A2 sind elektrische Bauelemente mit MEMS-Strukturen in einer Flip Chip-Anordnung bekannt.

Aus der WO 2014/094831 A1 sind Top-Port MEMS-Mikrofone mit einem monolithisch integrierten Schutz empfindlicher MEMS-Strukturen bekannt.

Das Einleiten mechanischer Spannungen in MEMS-Bauelement könnte durch weiche, leicht verformbare Federelemente als Verbindungsglieder zwischen Träger und MEMS-Bauelement verringert werden. Dann würde jedoch auch die mechanische Stabilität der Verbindung reduziert und entsprechende Module könnten Belastungstests, z. B. Falltests, nicht mehr bestehen.

Es besteht deshalb der Wunsch nach Modulen, die die widersprüchlichen Anforderungen: mechanische Stabilität bei gleichzeitig spannungsfreier Befestigung des MEMS-Bauelements erfüllen und ferner eine weitergehende Miniaturisierung erlauben, ohne Kompromisse bei der Signalqualität eingehen zu müssen.

Dazu werden im Folgenden ein Modul sowie verschiedene vorteilhafte Eigenschaften, die einzeln oder in Zusammenwirkung das nachfolgend beschriebene Modul gemäß unabhängigem Anspruch 1 verbessern können, angegeben. Abhängige Ansprüche geben vorteilhafte Ausgestaltungen des Moduls an.

Das Modul umfasst einen Träger mit einem ersten TemperaturAusdehnungskoeffizienten $K_1$, einem ersten Befestigungspunkt und einem zweiten Befestigungspunkt. Das Modul umfasst ferner ein MEMS-Bauelement mit MEMS-Strukturen, einem zweiten Temperatur-Ausdehnungskoeffizienten $K_2$, der vom ersten TemperaturAusdehnungskoeffizienten $K_1$ verschieden ist, einem ersten Befestigungspunkt und einem zweiten Befestigungspunkt. Ferner umfasst das Modul eine erste mechanische Verbindung zwischen dem ersten Befestigungspunkt des Trägers und dem ersten Befestigungspunkt des Bauelements. Außerdem hat das Modul eine zweite mechanische Verbindung zwischen dem zweiten Befestigungspunkt des Trägers und dem zweiten Befestigungspunkt des Bauelements. Die zweite mechanische Verbindung hat eine Kompensationsstruktur mit einem Temperatur-Ausdehnungskoeffizienten $K_K$. Die zwei Befestigungspunkte am MEMS-Bauelement haben einen horizontalen Abstand $d_1$ und die Befestigungspunkte auf dem Träger haben einen horizontalen Abstand $d_2$. Die Werte für $d_1$ und $d_2$ sind so gewählt, dass die Kompensationsstruktur bei einer Temperaturänderung die unterschiedlichen Längenänderungen von $d_1$ und $d_2$ kompensiert, sodass das MEMS-Bauelement bei verschiedenen Temperaturen spannungsfrei, aber fest mit dem Träger verbunden ist.

Es wurden herausgefunden, dass mechanische Verbindungen zwischen dem Träger und dem Bauelement so dimensioniert werden können und ihr Material, insbesondere ihre Ausdehnungskoeffizienten, so gewählt werden können, dass sich unterschiedliche Temperatur induzierte Längenänderungen exakt kompensieren lassen. Die mechanischen Verbindungen können dabei sehr massiv ausgeführt und dadurch extrem stabil sein, da sie keine mechanische Verformungsenergie aufnehmen müssen, um als Ausdehnungs-Puffer zwischen Träger und Bauelement zu wirken. Ein solches Modul kann deshalb eine mechanisch extrem stabile Verbindung zwischen Träger und Bauelement aufweisen, ohne dass die Funktionsweise des Bauelements durch eine mechanisehe Spannung beeinträchtigt wird. Deshalb ist es auch möglich, das Bauelement so dünn auszugestalten, dass den Anforderungen bezüglich der Kompaktheit genügt wird.

Zwar könnte auf die Kompensationsstruktur verzichtet werden, falls nur eine einzige mechanische Verbindung zwischen Träger und Bauelement existiert, denn dann könnten beide Körper ihren unterschiedlichen Längenausdehnungen ungestört nachgehen. Allerdings sollen die mechanischen Verbindungen in der Regel auch gleichzeitig elektrische Signalwege darstellen, sodass eine größere Anzahl an Verbindungen, z. B. zwei, drei oder vier, existieren.

Im einfachsten Fall gibt es zwei mechanische Verbindungen zwischen Träger und Bauelement. In einer solchen Ausführungsform überbrückt die Kompensationsstruktur den Abstand $\Delta d = d_2 - d_1$ entlang der Verbindungsrichtung zwischen den beiden Befestigungspunkten. Ferner gilt:

$$d_2 = d_1 \frac{K_x - K_1}{K_x - K_2} \qquad (1)$$

D. h. die Abstände d und die Ausdehnungskoeffizienten K sind entsprechend gewählt. Dazu gibt es mehrere Möglichkeiten: Bei gegebenen Ausdehnungskoeffizienten (die im Allgemeinen durch die Wahl der Materialien gegeben sind) können die Abstände der Befestigungspunkte gewählt werden. Insbesondere reicht es aus, einen der beiden Abstände zu wählen, wenn der jeweils andere und die Koeffizienten gegeben sind. Eine andere Möglichkeit bei gegebenen Abständen ist es, das Material der Kompensationsstruktur, das Material des Trägers oder das Material des Bauelements entsprechend der Gleichung zu wählen.

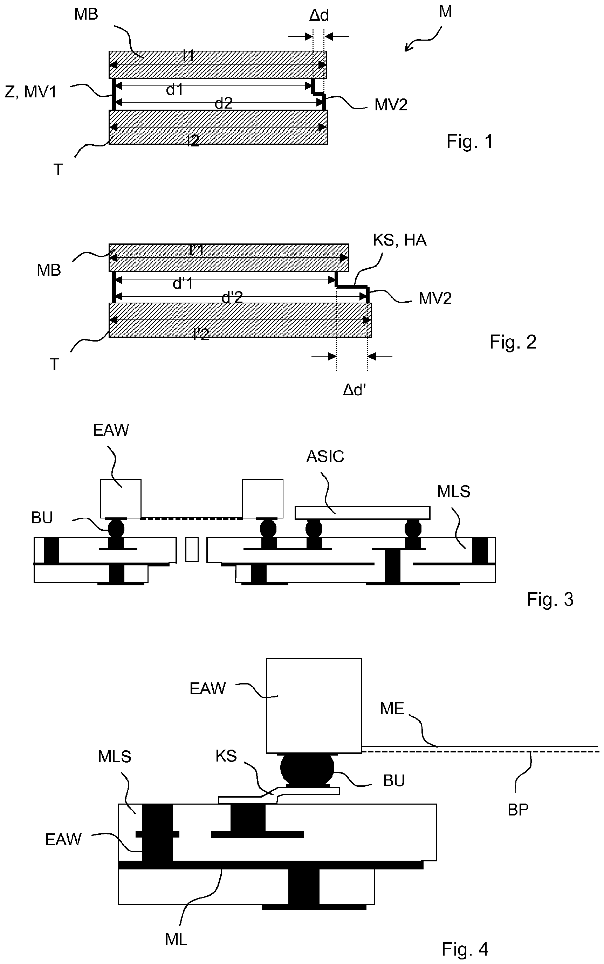

Die Bedeutung der Größen und die Funktionsweise der Kompensationsstruktur sind dabei in den Figuren 1 und 2 übersichtlich dargestellt.

Es ist möglich, dass der Ausdehnungskoeffizient $K_K$ der Kompensationsstruktur größer als der Größere der beiden Werte $K_1$ und $K_2$ ist:

$$K_K > \max (K_1, K_2) \qquad (2)$$

Alternativ ist es möglich, dass der Ausdehnungskoeffizient $K_K$ kleiner als der Kleinere der beiden Werte $K_1$ und $K_2$ ist. Entsprechend gilt:

$$K_K < \min (K_1, K_2) \qquad (3)$$

Es ist ferner möglich, dass die Kompensationsstruktur einen horizontalen Abschnitt umfasst, der auf oder oberhalb des Trägers angeordnet ist.

Insbesondere der horizontale Abschnitt dient bei einer Längenänderung des Trägers und des Bauelements durch eine eigene Längenänderung, die entsprechend angepasst ist, dazu, Spannungen zu vermeiden. Der horizontale Abschnitt überbrückt dabei einen horizontalen Bereich und verläuft im Wesentlichen parallel zur Oberfläche des Trägers. Allerdings ist es auch möglich, dass der horizontale Abschnitt in einem mehr oder weniger flachen Winkel auch die Höhendifferenz zwischen der Oberseite des Trägers und der Unterseite des Bauelements überbrückt.

Prinzipiell genügt eine einzige elektrische Verbindung, die auch gleichzeitig eine mechanische Verbindung sein kann, um ein Signal vom MEMS-Bauelement zum Träger weiterzuleiten. So könnte das Bauelement eine einzige floatende Elektrode aufweisen.

Allerdings ist es im Allgemeinen bevorzugt, zumindest ein Schaltungselement im Bauelement mit einer Spannung bzw. mit einem Strom zu beaufschlagen, sodass eine Mindestanzahl von zwei elektrischen Verbindungen bevorzugt ist. Wird eine weitere mechanische Verbindung hinzugefügt und das Bauelement an drei Punkten abgestützt, wird die mechanische Stabilität der Aufhängung noch einmal deutlich verbessert. Die Zahl der mechanischen und elektrischen Verbindungen zwischen Träger und Bauelement kann dabei noch deutlich größer sein. Ist das Bauelement z. B. ein elektroakustischer Wandler und umfasst mehrere Membranen oder mehrere Rückplatten, die jeweils mit einem elektrischen Potenzial beaufschlagt sein sollen, so können auch vier, fünf oder sechs elektrische Verbindungen zwischen Träger und Bauelement vorgesehen sein.

Es ist deshalb möglich, dass das Modul eine oder mehrere zusätzliche Kompensationsstrukturen, die zusätzliche Befestigungspunkte des Trägers mit zusätzlichen Befestigungspunkten des Bauelements verbinden, ferner umfasst.

Zumindest eine der mechanischen Verbindungen, aber bevorzugt mehrere oder alle mechanischen Verbindungen, umfassen dabei eine Kompensationsstruktur, die zusammen mit den übrigen Kompensationsstrukturen bei einer Temperaturänderungen die unterschiedlichen Längenänderungen von Träger und MEMS-Bauelement kompensiert. Die einzelnen mechanischen Verbindungen und/oder deren Kompensationsstrukturen können dabei den gleichen Aufbau haben und aus den gleichen Materialien ausgewählt sein. Hat das Modul mehr als zwei Kompensationsstrukturen, so ist es nicht länger möglich, die Kompensationsstrukturen entlang einer Verbindungslinie zwischen zwei Befestigungspunkten auszurichten. Vielmehr hat ein solches Modul ein gemeinsames Zentrum, von dem aus gesehen die Kompensationsstrukturen in radialer Richtung angeordnet sind. Bei mehr als zwei Kompensationsstrukturen erhöht sich die Dimensionalität der Geometrie der Anordnungen der Kompensationsstrukturen. Bei lediglich zwei Befestigungspunkten pro Körper ist die unterschiedliche Längenausdehnung ein eindimensionales Problem. Bei drei oder mehr Kompensationsstrukturen liegen unterschiedliche Ausdehnungskoeffizienten in zwei Dimensionen vor, wobei jeder Ausdehnungskoeffizient $K_1$, $K_2$, $K_K$ verschiedene Komponenten in x- bzw. y-Richtung aufweisen kann.

Sind die Ausdehnungskoeffizienten isotrop, alle Kompensationsstrukturen gleich aufgebaut und rotationssymmetrisch um ein gemeinsames Zentrum angeordnet, lässt sich die unterschiedliche Temperaturausdehnung wieder auf ein eindimensionales Problem zurückführen, für das Gleichung (1) gilt. Dabei stellen die Größen $d_1$ und $d_2$ die Abstände des jeweiligen Befestigungspunkts der Kompensationsstruktur vom gemeinsamen Zentrum dar.

Es ist möglich, dass der Träger ein keramisches Material oder ein organisches Material, z. B. ein Leiterplattenmaterial und/oder BCB (Benzocyclobuten) umfasst.

Es ist ferner möglich, dass das MEMS-Bauelement einen Körper aus einem Halbleitermaterial, z. B. Si (Silizium), umfasst.

Der Träger kann dabei mehrere dielektrische Lagen, zwischen denen strukturierte Metallisierungslagen angeordnet sind, aufweisen.

Es ist möglich, dass zumindest eine Kompensationsstruktur oder alle Kompensationsstrukturen ein Metall umfassen. Das Metall kann beispielsweise Cu (Kupfer), Ag (Silber), Au (Gold), Ni (Nickel) oder ein weiteres Metall sein, das mit üblichen Materialabscheidungsprozessen an der Oberseite des Trägers aufgebracht werden kann.

Es ist vorteilhaft, wenn alle Kompensationsstrukturen radialsymmetrisch um ein gemeinsames Zentrum angeordnet sind. Die Kompensationsstrukturen brauchen dabei nicht alle den gleichen Abstand zum Zentrum aufweisen. Es ist ebenso möglich, dass eine erste Gruppe an Kompensationsstrukturen einen ersten Abstand und eine zweite Gruppe an Kompensationsstrukturen einen zweiten Abstand usw. vom Zentrum aufweisen. Die Kompensationsstrukturen sind dann jeweils entlang von gedachten Kreislinien um das Zentrum angeordnet. Eine Drehung der Kompensationsstrukturen um einen bestimmten Winkel um das Zentrum führt die Kompensationsstrukturen dann wieder in sich selbst über.

Es ist möglich, dass zumindest eine der Kompensationsstrukturen oder mehrere oder alle Kompensationsstrukturen mit mehreren Befestigungspunkten auf dem Trägern und/oder mehreren Befestigungspunkten auf dem MEMS-Bauelement verbunden sind. Eine solche Multi-Punkt-Verbindung erhöht die Ausfallsicherheit der Kompensationsstruktur für den Fall, dass sie sich an einem Befestigungspunkt vom Träger oder Bauelement lösen sollte.

Es ist möglich, dass das MEMS-Bauelement einen Körper mit einer Höhe $\leq 700\ \mu$m und mit einer Seitenlänge zwischen 0.3 mm und 5 mm aufweist.

Entsprechend dünne MEMS-Bauelemente können aufgrund der oben beschriebenen Kompensationsstrukturen quasi spannungsfrei über einen weiten Temperaturbereich befestigt werden und tragen zur Gesamthöhe des Moduls im Vergleich mit konventionellen Befestigungen deutlich weniger bei.

Es ist möglich, dass das MEMS-Bauelement ein elektroakustischer Wandler ist. Der elektroakustische Wandler kann dabei zumindest eine Membran und zumindest eine Rückplatte, einen Körper aus Silizium mit einem strukturierten Hohlraum hinter der Membran und zumindest zwei elektrische Anschlüsse umfassen.

Das Modul stellt dabei ein Mikrofon dar, wobei das Mikrofon noch einen weiteren Chip umfassen kann, in dem z. B. ein ASIC integriert ist.

Ein solches Mikrofon kann dabei drei oder mehr Kompensationsstrukturen im Modul aufweisen, die rotationssymmetrisch um ein Zentrum angeordnet sind. Der elektroakustische Wandler hat ferner einen Signaleingang, der im Bereich des Zentrums angeordnet ist.

Das Material der Kompensationsstrukturen kann dabei im Wesentlichen jedes Material, bevorzugt jedes leitende Material, umfassen, dessen thermischer Ausdehnungskoeffizient kleiner als der Kleinere der beiden Körper ist. Dann gilt: $d_2 < d_1$. Alternativ kann der thermische Ausdehnungskoeffizient der Kompensationsstruktur auch größer als der Größere der Ausdehnungskoeffizienten der Körper sein. Dann gilt: $d_2 > d_1$.

Verfahren zur Entwicklung entsprechender Module können dabei die Optimierungs-Software TopOpt verwenden, die an der Technischen Universität Dänemarks (DTU) entwickelt wurde. Insbesondere wenn äußere Zwangsbedingungen eine Abkehr von einem rein eindimensionalen Aufbau erzwingen, z. B. weil eine Schalleintrittsöffnung nicht durch die Kompensationsstrukturen verdeckt sein darf, weil die mechanische Stabilität bezüglich besonders strenger Falltests optimiert sein muss usw., sind softwaregestützte Simulationstools vorteilhaft.

Es ist möglich, dass die Kompensationsstruktur dazu vorgesehen ist, das MEMS-Bauelement elastisch, d.h. federnd, zu befestigen. Dann können z. B. Beschleunigungsspitzen und/oder Kräfte beim Einbau in ein Telefon aufgenommen werden und mechanisch bedingte Verformungen abgeschwächt oder vermieden werden.

Das Modul und die Wirkungsprinzipien der Kompensationsstrukturen werden anhand der schematischen Figuren und anhand von nicht einschränkenden Ausführungsbeispielen näher erläutert.

Dabei zeigen:

Fig. 1: die räumliche Anordnung eines Trägers, eines Bau-elements und zweier mechanischer Verbindungen bei einer ersten Temperatur,

Fig. 2: dieselbe Anordnung bei einer zweiten Temperatur,

Fig. 3: ein beispielhaftes konventionelles Mikrofon,

Fig. 4: einen Ausschnitt eines Mikrofons, bei dem ein elektroakustischer Wandler über eine Kompensations-struktur mit einem Mehrlagensubstrat verbunden und verschaltet ist,

Fig. 5: eine perspektivische Ansicht eines Moduls mit einem Bauelement, das durch mechanische Verbindungen mit einem Träger verbunden ist,

Fig. 6: eine perspektivische Ansicht einer Kompensations-struktur der Fig. 5,

Fig. 7: eine mechanische Verbindung mit einer im Wesentlichen eindimensionalen Ausrichtung,

Fig. 8: eine mechanische Verbindung mit einer zweidimensionalen Ausrichtung,

Fig. 9: eine Weiterbildung der mechanischen Verbindung der Fig. 6 mit spannungsreduzierten horizontalen Abschnitten.

Figur 1 zeigt eine Anordnung eines Moduls M mit einem MEMS-Bauelements MB auf einem Träger T. Das Bauelement MB und der Träger T sind über eine erste mechanische Verbindung MV1 und über eine zweite mechanische Verbindung MV2 verbunden. Der Abstand der Verbindungspunkte am Bauelement ist $d_1$. Der Abstand der Verbindungs-punkte auf dem Träger T ist $d_2$. Bei einer bestimmten Temperatur hat das Bauelement eine Länge $l_1$ und der Träger eine Länge $l_2$.

Sind die Dimensionen und die Materialien entsprechend gewählt, ergibt sich eine vollständige Kompensation der Längenausdehnung und damit eine vollständige Vermeidung thermisch induzierter Spannungen in dem ganzen Temperaturbereich, in dem sich die Materialien linear mit einer Temperaturänderung ausdehnen.

Figur 2 zeigt den gleichen Aufbau bei einer Temperatur, die um eine Differenztemperatur $\Delta T$ von der Temperatur der in Figur 1 gezeigten Situation abweicht. Die Länge des Bauelements MB ist dabei von $l_1$ auf $l'_1$ angewachsen. Der Abstand zwischen den Befestigungspunkten am Bauelement ist von $d_1$ auf $d_1'$ angewachsen:

$$d'_1 = d_1 + d_1 K_1 \Delta T = d_1 (1 + K_1 \Delta T) \qquad (4)$$

Der Abstand zwischen den Befestigungspunkten am Träger ist von $d_2$ auf $d_2'$ angewachsen:

$$d'_2 = d_2 + d_2 K_2 \Delta T = d_2 (1 + K_2 \Delta T) \qquad (5)$$

Beträgt der Abstand der Befestigungspunkte bei der Temperatur der Figur 1 noch $\Delta d$:

$$\Delta d = d_2 - d_1 \qquad (6),$$

so wächst der Abstand auf $\Delta d'$ an:

$$\Delta d' = d'_2 - d'_1 \qquad (7)$$

Die zweite mechanische Verbindung MV2 hat dabei eine Kompensationsstruktur KS mit einem horizontalen Abschnitt HA, der die Längendifferenz $\Delta d$ bzw. $\Delta d'$ überbrückt. Relativ zu den Abständen d ist das Material der Kompensationsstruktur KS bzw. deren horizontalen Abschnitts HA so gewählt, dass die unterschiedliche Längenausdehnung Δd' - Δd kompensiert wird. Bei einer linearen Ausdehnung gilt:

$$\Delta d' = \Delta d(1 + K_x \Delta T) \qquad (8)$$

Aus (4) und (5) folgt:

$$\Delta d' = \Delta d + (d_2 K_2 - d_1 K_1)\Delta T \qquad (9)$$

Aus (8) und (9) folgt:

$$\Delta d(1 + K_K \Delta T) = \Delta d + (d_2 K_2 - d_1 K_1)\Delta T \qquad (10)$$

Daraus folgt:

$$\Delta d K_K = d_2 K_2 - d_1 K_1 \qquad (11)$$

Aus Gleichung (11) ergibt sich direkt Gleichung (1).

Hat der Träger T einen größeren Temperatur-Ausdehnungskoeffizienten als das MEMS-Bauelement MB, so ist $d_2 > d_1$. Im umgekehrten Fall ($K_1 > K_2$) müsste $d_1 > d_2$ sein oder der thermische Ausdehnungskoeffizient der Kompensationsstruktur KS kleiner als der thermische Ausdehnungskoeffizient des Trägers T sein. Anstelle einer Kompensationsstruktur mit kleinem TemperaturAusdehnungskoeffizienten kann der Aufbau umgekehrt werden.

Figur 3 zeigt einen Ausschnitt eines konventionellen Mikrofons, bei dem ein elektroakustischer Wandler EAW über Bump-Verbindungen BU mit einem Mehrlagensubstrat MLS verbunden und verschaltet ist. Neben dem elektroakustischen Wandler EAW ist ein Chip mit einem ASIC auf dem Mehrlagensubstrat MLS angeordnet. Unterschiedliche Ausdehnungskoeffizienten von Mehrlagensubstrat, Wandler EAW und Chip ASIC stören die Funktionalität des Wandlers EAW deutlich mehr als die im Allgemeinen ausschließlich elektrische Funktionalität des Chips ASIC. Denn der Wandler reagiert empfindlicher auf mechanische Spannungen als der Chip ASIC.

Figur 4 zeigt eine entsprechende Verbesserung des Mikrofons, bei dem der elektroakustische Wandler, hier mit einer Membran ME und einer Rückplatte BP über eine Bump-Verbindung nicht direkt mit dem Mehrlagensubstrat MLS, sondern mit einer Kompensationsstruktur KS verbunden und verschaltet ist. An der Stelle, die zur Verbindung mit dem Lotmaterial vorgesehen ist, kann ein Lötpad angeordnet sein. Analog kann auch der Wandler EAW über Lötpads verfügen, damit eine dauerhafte Lotverbindung erfolgen kann.

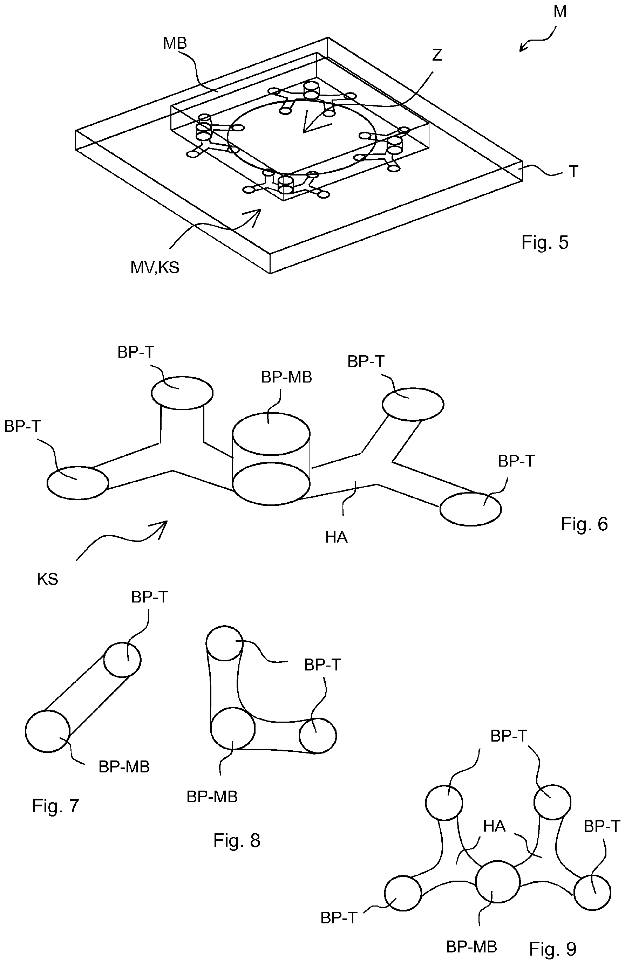

Figur 5 zeigt eine perspektivische Ansicht eines Moduls M, bei dem ein MEMS-Bauelement MB auf einem Träger T angeordnet und über mechanische Verbindungen bzw. deren Kompensationsstrukturen KS verbunden und verschaltet ist. Das Modul umfasst dabei vier mechanische Verbindungen, die rotationssymmetrisch um ihr gemeinsames Zentrum Z angeordnet und ausgerichtet sind. Jede der mechanischen Verbindungen hat vier Kontaktstellen mit dem Träger T und eine Kontaktstelle mit dem Bauelement MB.

Im Bereich des Zentrums Z hat das Bauelement MB eine Schalleintrittsöffnung. Dabei sind die mechanischen Verbindungen MV so um die Schalleintrittsöffnung gruppiert, dass ein akustisches Signal problemlos empfangen werden kann.

Figur 6 zeigt eine mechanische Verbindung der Figur 5 in perspektivischer Ansicht. Die mechanische Verbindung hat vier Befestigungspunkte BP-T, mit denen sie auf dem Träger befestigt ist. Ferner hat die mechanische Verbindung einen Befestigungspunkt BP-MB, über den sie mit dem MEMS-Bauelement verbunden ist. Die mechanische Verbindung umfasst ferner horizontale Abschnitte HA, die einen Längenausgleich in zwei Dimensionen ermöglichen.

Die horizontalen Abschnitte HA können dabei leicht gegenüber den Befestigungspunkten auf dem Träger BP-T angehoben sein, damit sich keine mechanischen Spannungen zwischen den horizontalen Abschnitten HA und dem Träger T ausbilden können.

Solche mechanischen Verbindungen können während der Herstellungsprozesse gefertigt werden, indem die horizontalen Abschnitte HA auf ein Opfermaterial auf dem Träger T aufgebracht werden, das nach dem Aufbringen des Materials der horizontalen Abschnitte HA entfernt wird.

Figur 7 zeigt eine im Wesentlichen eindimensional ausgestaltete mechanische Verbindung, die genau einen Befestigungspunkt auf dem Träger BP-T und genau einen Befestigungspunkt für das MEMS-Bauelement BP-MB aufweist. Ein horizontaler Abschnitt dazwischen verbindet die beiden Punkte.

Figur 8 zeigt eine Ausführungsform einer mechanischen Verbindung, die horizontale Abschnitte in zwei Richtungen aufweist. Entsprechend gibt es zwei Befestigungspunkte BP-T zum Träger und einen Befestigungspunkt BP-MB zum Bauelement.

Die horizontalen Abschnitte sind dabei - im Gegensatz zur Ausgestaltung der Figur 7 - nicht durch Abschnitte mit geradlinig verlaufenden Kanten, sondern durch Abschnitte mit gekrümmt verlaufenden Kanten ausgestaltet, um mechanische Spannungskonzentrationen zu vermeiden. Entsprechend zeigt Figur 9 eine Ausführungsform einer mechanischen Verbindung mit vier Befestigungspunkten BP-T zum Träger und einen Befestigungspunkt BP-MB zum Bauelement, wobei die horizontalen Abschnitte HA ebenfalls durch Abschnitte mit gekrümmt verlaufenden Kanten ausgestaltet sind.

Das Modul ist nicht auf die gezeigten Ausführungsbeispiele beschränkt. Module mit weiteren mechanischen und/oder elektrischen Verbindungen zur Temperaturkompensation oder Module mit weiteren Bauelementen stellen ebenso erfindungsgemäße Realisierungen dar.

Bezugszeichenliste

| | |
|---|---|
| ASIC: | ASIC-Chip |
| BP: | Rückplatte |
| BP-MB: | Befestigungspunkt zum Bauelement |
| BP-T: | Befestigungspunkt zum Träger |
| BU: | Bump-Verbindung |
| $d_1$: | Abstand der Befestigungspunkte am MEMS-Bauelement bzw. Abstand der Befestigungspunkte am MEMS-Bauelement vom Zentrum |
| $d_2$: | Abstand der mechanischen Verbindungen auf dem Träger bzw. Abstand des Befestigungspunkts der mechanischen Verbindung vom Zentrum auf dem Träger |
| EAW: | elektroakustischer Wandler |
| HA: | horizontaler Abschnitt |
| $K_1$: | Temperatur-Ausdehnungskoefizient des Trägers |
| $K_2$: | Temperatur-Ausdehnungskoefizient des Bauelements |
| $K_K$: | Temperatur-Ausdehnungskoefizient der Kompensations-struktur |
| KS: | (Temperatur-)Kompensationsstruktur |
| $l_1$: | Länge des MEMS-Bauelements |
| $l_2$: | Länge des Trägers |
| M: | Modul |
| MB: | MEMS-Bauelement |
| ME: | Membran |
| MLS: | Mehrlagensubstrat |
| MV: | mechanische Verbindung |
| MV1, MV2: | erste, zweite mechanische Verbindung |
| T: | Träger |
| Z: | (Symmetrie-)Zentrum |
| $\Delta d$, $\Delta d'$: | durch die Kompensationsstruktur zu überbrückender horizontaler Abstand |

**Patentansprüche**

1.  Elektrisches Modul (M), umfassend

- ein Träger (T) mit einem ersten Temperatur-Ausdehnungskoeffizieten $K_1$, einem ersten Befestigungspunkt und einem zweiten Befestigungspunkt,
- ein MEMS-Bauelement (MB) mit MEMS-Strukturen (ME, BP), einem zweiten Temperatur-Ausdehungskoeffizienten $K_2 \neq K_1$, einem ersten Befestigungspunkt und einem zweiten Befestigungspunkt,
- eine erste mechanische Verbindung (MV1) zwischen dem ersten Befestigungspunkt des Trägers (T) und dem ersten Befestigungspunkt des Bauelements (MB),
- eine zweite mechanische Verbindung (MV2) zwischen dem zweiten Befestigungspunkt des Trägers (T) und dem zweiten Befestigungspunkt des Bauelements (MB) mit einer Kompensationsstruktur (KS) mit einem TemperaturAusdehnungskoeffizienten $K_K$,
wobei

- die Befestigungspunkte am MEMS-Bauelement (MB) einen horizontalen Abstand $d_1$ und die Befestigungspunkte auf dem Träger (T) einen horizontalen Abstand $d_2$ haben,
- die Werte für $d_1$ und $d_2$ so gewählt sind, dass die Kompensationsstruktur (KS) bei einer Temperaturänderung die unterschiedlichen Längenänderungen von $d_1$ und $d_2$ kompensiert, und das MEMS-Bauelement (MB) bei verschiedenen Temperaturen spannungsfrei mit dem Träger verbunden ist,
- die Kompensationsstruktur (KS) den Abstand $\Delta d = d_2 - d_1$ entlang der Verbindungsrichtung zwischen den beiden zweiten Befestigungspunkten überbrückt und
- die Gleichung $d_2 = d_1(K_K - K_1)/(K_K - K_2)$ erfüllt ist.

2. Modul nach dem vorherigen Anspruch, wobei $K_K$

- entweder größer als der größere der beiden Werte $K_1$ und $K_2$ ist: $K_K > \max(K_1, K_2)$ oder
- kleiner als der kleinere der beiden Werte $K_1$ und $K_2$ ist: $K_K < \min(K_1, K_2)$.

3. Modul nach einem der vorherigen Ansprüche, wobei die Kompensationsstruktur (KS) einen horizontalen Abschnitt (HA) umfasst, der auf oder oberhalb des Trägers (T) angeordnet ist.

4. Modul nach einem der vorherigen Ansprüche, ferner umfassend eine oder mehrere zusätzliche Kompensationsstrukturen (KS), die zusätzliche Befestigungspunkte des Trägers (TS) mit zusätzlichen Befestigungspunkten des MEMS-Bauelements (MB) verbinden.

5. Modul nach einem der vorherigen Ansprüche, wobei die erste mechanische Verbindung (MV1) eine Kompensationsstruktur (KS) umfasst, die zusammen mit den übrigen Kompensationsstrukturen (KS) bei einer Temperaturänderung die unterschiedlichen Längenänderungen von Träger (T) und MEMS-Bauelement (MB) kompensiert.

6. Modul nach einem der vorherigen Ansprüche, bei dem zumindest eine Kompensationsstruktur (KS) eine elektrische Verschaltung zwischen Träger (T) und MEMS-Bauelement (MB) bildet.

7. Modul nach einem der vorherigen Ansprüche, wobei der Träger (T) ein keramisches Material oder ein organisches Leiterplattenmaterial umfasst.

8. Modul nach dem vorherigen Anspruch, wobei der Träger (T) mehrere dielektrische Lagen, zwischen denen strukturierte Metallisierungslagen (ML) angeordnet sind, aufweist.

9. Modul nach einem der vorherigen Ansprüche, wobei das MEMS-Bauelement (MB) einen Körper aus einem Halbleitermaterial umfasst.

10. Modul nach einem der vorherigen Ansprüche, wobei zumindest eine Kompensationsstruktur (KS) ein Metall umfasst.

11. Modul nach einem der vorherigen Ansprüche, wobei alle Kompensationsstrukturen (KS) radialsymmetrisch um ein Zentrum (Z) angeordnet sind.

12. Modul nach einem der vorherigen Ansprüche, wobei zumindest eine Kompensationsstruktur (KS) mit mehreren Befestigungspunkten auf dem Träger (T) und/oder mit mehreren Befestigungspunkten auf dem MEMS-Bauelement (MB) verbunden ist.

13. Modul nach einem der vorherigen Ansprüche, wobei das MEMS-Bauelement (MB) einen Körper mit einer Höhe $\leq$ 700 $\mu$m und mit einer Seitenlänge zwischen 0.3 mm und 5 mm aufweist.

14. Mikrofon, umfassend ein Modul (M) nach einem der vorhergehenden Ansprüche, wobei das MEMS-Bauelement (MB) ein elektroakustischer Wandler (EAW) ist.

15. Mikrofon nach dem vorherigen Anspruch, wobei

- das Modul (M) drei oder mehr Kompensationsstrukturen (KS) aufweist, die rotationssymmetrisch um ein Zentrum (Z) angeordnet sind, und

- der elektroakustische Wandler (EAW) einen Schalleingang im Zentrum (Z) umfasst.

16. Mikrofon nach einem der vorherigen Ansprüche, wobei die Kompensationsstruktur (KS) dazu vorgesehen ist, das MEMS-Bauelement (MB) elastisch zu befestigen.

**Claims**

1. Electric module (M), comprising

   - a carrier (T) having a first thermal expansion coefficient $K_1$, a first mounting point and a second mounting point,
   - a MEMS component (MB) with MEMS structures (ME, BP), a second thermal expansion coefficient $K_2 \neq K_1$, a first mounting point and a second mounting point,
   - a first mechanical connection (MV1) between the first mounting point of the carrier (T) and the first mounting point of the component (MB),
   - a second mechanical connection (MV2) between the second mounting point of the carrier (T) and the second mounting point of the component (MB) with a compensation structure (KS) with a thermal expansion coefficient $K_k$,
   wherein
   - the mounting points on the MEMS component (MB) are spaced apart by a horizontal distance $d_1$ and the mounting points on the carrier (T) are spaced apart by a horizontal distance $d_2$,
   - the values for $d_1$ and $d_2$ are selected such that in the case of a change in the temperature the compensation structure (KS) compensates the different changes in length of $d_1$ and $d_2$, and in the case of different temperatures the MEMS component (MB) is connected in a stress-free fashion to the carrier,
   - the compensation structure (KS) bridges the distance $\Delta d = d_2 - d_1$ along the connecting direction between the two second mounting points, and
   - the equation $d_2 = d_1 (K_K - K_1) / (K_K - K_2)$ is satisfied.

2. Module according to the preceding claim, wherein $K_K$

   - is either larger than the larger of the two values $K_1$ and $K_2$: $K_K > \max (K_1, K_2)$ or
   - smaller than the smaller of the two values $K_1$ and $K_2$: $K_K < \min (K_1, K_2)$.

3. Module according to one of the preceding claims, wherein the compensation structure (KS) comprises a horizontal section (HA) which is arranged on or above the carrier (T).

4. Module according to one of the preceding claims, additionally comprising one or more additional compensation structures (KS) which connect additional mounting points of the carrier (TS) to additional mounting points of the MEMS component (MB).

5. Module according to one of the preceding claims, wherein the first mechanical connection (MV1) comprises a compensation structure (KS) which, together with the other compensation structures (KS), compensates the different changes in length of the carrier (T) and MEMS component (MB) in the case of a change in temperature.

6. Module according to one of the preceding claims, in which at least one compensation structure (KS) forms an electrical connection between the carrier (T) and MEMS component (MB).

7. Module according to one of the preceding claims, wherein the carrier (T) comprises a ceramic material or an organic circuit board material.

8. Module according to the preceding claim, wherein the carrier (T) has a plurality of dielectric layers between which structured metallization layers (ML) are arranged.

9. Module according to one of the preceding claims, wherein the MEMS component (MB) comprises a body made of a semiconductor material.

10. Module according to one of the preceding claims, wherein at least one compensation structure (KS) comprises a metal.

**11.** Module according to one of the preceding claims, wherein all the compensation structures (KS) are arranged radially symmetrically about a center (Z).

**12.** Module according to one of the preceding claims, wherein at least one compensation structure (KS) is connected to a plurality of mounting points on the carrier (T) and/or to a plurality of mounting points on the MEMS component (MB).

**13.** Module according to one of the preceding claims, wherein the MEMS component (MB) has a body with a height $\leq$ 700 $\mu$m and with a side length between 0.3 mm and 5 mm.

**14.** Microphone comprising a module (M) according to one of the preceding claims, wherein the MEMS component (MB) is an electro-acoustic transducer (EAW).

**15.** Microphone according to the preceding claim, wherein

- the module (M) has three or more compensation structures (KS) which are arranged in a rotationally symmetrical fashion about a center (Z), and
- the electro-acoustic transducer (EAW) comprises a sound input in the center (Z).

**16.** Microphone according to one of the preceding claims, wherein the compensation structure (KS) is provided for mounting the MEMS component (MB) elastically.

**Revendications**

**1.** Module électrique (M), comprenant

- un élément porteur (T) ayant un premier coefficient de dilatation thermique $K_1$, un premier point de fixation et un deuxième point de fixation,
- un composant MEMS (MB) ayant des structures MEMS (ME, BP), un deuxième coefficient de dilatation thermique $K_2 \neq K_1$, un premier point de fixation et un deuxième point de fixation,
- une première liaison mécanique (MV1) entre le premier point de fixation de l'élément porteur (T) et le premier point de fixation du composant (MB),
- une deuxième liaison mécanique (MV2) entre le deuxième point de fixation de l'élément porteur (T) et le deuxième point de fixation du composant (MB), pourvue d'une structure de compensation (KS) ayant un coefficient de dilatation thermique $K_K$,
- les points de fixation au niveau du composant MEMS (MB) ayant un écart horizontal $d_1$ et les points de fixation sur l'élément porteur (T) ayant un écart horizontal $d_2$,
- les valeurs de $d_1$ et $d_2$ étant choisies de telle sorte que la structure de compensation (KS) compense les différentes variations de longueur de $d_1$ et $d_2$ lors d'une variation de la température, et le composant MEMS (MB) étant relié à l'élément porteur sans contrainte aux différentes températures,
- la structure de compensation (KS) pontant l'écart $\Delta d = d_2 - d_1$ le long de la direction de liaison entre les deux deuxièmes points de fixation et
- l'équation $d_2 = d_1 (K_K - K_1) / (K_K - K_2)$ étant vérifiée.

**2.** Module selon la revendication précédente, avec lequel $K_K$

- est soit supérieur à la plus grande des deux valeurs $K_1$ et $K_2$ : $K_K > \max(K_1, K_2)$, soit
- est inférieur à la plus petite des deux valeurs $K_1$ et $K_2$ : $K_K < \min(K_1, K_2)$.

**3.** Module selon l'une des revendications précédentes, la structure de compensation (KS) comprenant une portion horizontale (HA) qui est disposée sur ou au-dessus de l'élément porteur (T).

**4.** Module selon l'une des revendications précédentes, comprenant en outre une ou plusieurs structures de compensation (KS) supplémentaires qui relient des points de fixation supplémentaires de l'élément porteur (TS) à des points de fixation supplémentaires du composant MEMS (MB) .

**5.** Module selon l'une des revendications précédentes, la première liaison mécanique (MV1) comprenant une structure de compensation (KS) qui, conjointement avec les autres structures de compensation (KS), compense les différentes variations de longueur de l'élément porteur (T) et du composant MEMS (MB) lors d'une variation de la température.

6.  Module selon l'une des revendications précédentes, dans lequel au moins une structure de compensation (KS) formant une interconnexion électrique entre l'élément porteur (T) et le composant MEMS (MB).

7.  Module selon l'une des revendications précédentes, l'élément porteur (T) comprenant un matériau céramique ou un matériau de circuit imprimé organique.

8.  Module selon la revendication précédente, l'élément porteur (T) possédant plusieurs couches diélectriques entre lesquelles sont disposées des couches de métallisation structurées (ML).

9.  Module selon l'une des revendications précédentes, le composant MEMS (MB) comprenant un corps en un matériau semiconducteur.

10. Module selon l'une des revendications précédentes, au moins une structure de compensation (KS) comprenant un métal.

11. Module selon l'une des revendications précédentes, toutes les structures de compensation (KS) étant disposées en symétrie radiale autour d'un centre (Z).

12. Module selon l'une des revendications précédentes, au moins une structure de compensation (KS) étant reliée à plusieurs points de fixation sur l'élément porteur (T) et/ou à plusieurs points de fixation sur le composant MEMS (MB).

13. Module selon l'une des revendications précédentes, le composant MEMS (MB) possédant un corps ayant une hauteur $\leq 700\ \mu m$ et ayant une longueur latérale comprise entre 0,3 mm et 5 mm.

14. Microphone, comprenant un module (M) selon l'une des revendications précédentes, le composant MEMS (MB) étant un convertisseur électroacoustique (EAW).

15. Microphone selon la revendication précédente,

    - le module (M) possédant au moins trois structures de compensation (KS) qui sont disposées en symétrie de rotation autour d'un centre (Z), et
    - le convertisseur électroacoustique (EAW) comprenant une entrée de son au centre (Z).

16. Microphone selon l'une des revendications précédentes, la structure de compensation (KS) étant conçue pour réaliser une fixation élastique du composant MEMS (MB).

MB

Δd

M

l1

Z, MV1

d1

d2

MV2

l2

T

**Fig. 1**

MB

l'1

KS, HA

d'1

d'2

MV2

l'2

T

Δd'

**Fig. 2**

EAW

ASIC

MLS

BU

**Fig. 3**

EAW

ME

MLS

KS

BU

EAW

BP

ML

**Fig. 4**

MB

Z

M

T

MV,KS

Fig. 5

BP-T

BP-MB

BP-T

BP-T

BP-T

HA

Fig. 6

KS

BP-T

BP-MB

Fig. 7

BP-T

BP-MB

Fig. 8

BP-T

HA

BP-T

BP-T

BP-T

BP-MB

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010012042 A1
- US 2003038415 A1
- US 2010157562 A1
- EP 2006248 A2
- WO 2014094831 A1